# DEMANDE DE BREVET EUROPEEN

(11) **EP 4 020 598 A1**
(43) Date de publication de la demande: **29.06.2022**
(21) Numéro de dépôt: 21214948.8
(22) Date de dépôt: 16.12.2021
(51) Int. Cl.: H01L 29/861, H01L 21/329, H01L 29/06, H01L 29/40

(54) **DIODES FINES**

(30) Priorité: 24.12.2020 FR 2014147
(71) Demandeur: STMicroelectronics (Tours) SAS, 37100 Tours (FR)
(72) Inventeur: YVON, Arnaud, 37540 SAINT-CYR SUR LOIRE (FR); JAOUEN, Lionel, 37540 ST CYR SUR LOIRE (FR)
(74) Mandataire: Cabinet Beaumont

(57) **Abrégé**

La présente description concerne un dispositif comprenant une diode (10) dans laquelle l'anode de la diode comprend des première (30), deuxième (32) et troisième (34) zones, la première zone (30) recouvrant partiellement la deuxième zone (32) et ayant un niveau de dopage supérieur au niveau de dopage de la deuxième zone (32), la deuxième zone (32) recouvrant partiellement la troisième zone (34) et ayant un niveau de dopage supérieur au niveau de dopage de la troisième zone (34), une première couche isolante (24) chevauchant partiellement les première et deuxième zones.

## Description

### Domaine technique

La présente description concerne de façon générale les dispositifs électroniques et leurs procédés de fabrication, et plus précisément les dispositifs comprenant des diodes.

### Technique antérieure

Des dispositifs électroniques, en particulier des dispositifs électroniques pouvant être installés dans des automobiles, comprennent des modules comprenant une diode et un transistor bipolaire à grille isolée (IGBT - "Insulated Gate Bipolar Transistor"), dédiés au contrôle du moteur. Dans ce cadre, les diodes peuvent recevoir une vitesse de commutation en courant pouvant atteindre 5000 A/µs.

Typiquement, des diodes fines sont utilisées dans ce type de module, car elles permettent d'associer la diode et le transistor sur une épaisseur relativement similaire. Cependant, les diodes fines sont adaptées à des vitesses de commutation en courant autour de 2000 A/µs. Des valeurs plus élevées de commutation entrainent une dégradation, voire une destruction, de la diode.

### Résumé de l'invention

Il existe un besoin de diodes adaptées à des commutations en courant élevées.

Un mode de réalisation pallie tout ou partie des inconvénients des dispositifs comprenant des diodes connus.

Un mode de réalisation prévoit un dispositif comprenant une diode dans laquelle l'anode de la diode comprend des première, deuxième et troisième zones, la première zone recouvrant partiellement la deuxième zone et ayant un niveau de dopage supérieur au niveau de dopage de la deuxième zone, la deuxième zone recouvrant partiellement la troisième zone et ayant un niveau de dopage supérieur au niveau de dopage de la troisième zone, une première couche isolante chevauchant partiellement les première et deuxième zones.

Un mode de réalisation prévoit un procédé de fabrication d'une diode comprenant la formation de première, deuxième et troisième zones, la première zone recouvrant partiellement la deuxième zone et ayant un niveau de dopage supérieur au niveau de dopage de la deuxième zone, la deuxième zone recouvrant partiellement la troisième zone et ayant un niveau de dopage supérieur au niveau de dopage de la troisième zone, une première couche isolante chevauchant partiellement les première et deuxième zones.

Selon un mode de réalisation, la première zone est recouverte par la première couche isolante et une couche conductrice.

Selon un mode de réalisation, le niveau de dopage de la première zone est au moins 10 fois supérieur au niveau de dopage de la deuxième zone et le niveau de dopage de la deuxième zone est au moins 10 fois supérieur au niveau de dopage de la troisième zone.

Selon un mode de réalisation, le niveau de dopage de la première zone est compris entre 1e17 atomes/cm3 et 1e20 atomes/cm3, le niveau de dopage de la deuxième zone est compris entre 1e15 atomes/cm3 et 1e17 atomes/cm3, et le niveau de dopage de la troisième zone est compris entre 1e14 atomes/cm3 et 1e17 atomes/cm3.

Selon un mode de réalisation, le chevauchement de la première zone par la première couche isolante s'étend sur une longueur au moins égale à 5 µm, de préférence au moins égale à 10 µm.

Selon un mode de réalisation, le chevauchement de la première zone par la première couche isolante s'étend sur une portion comprise entre un quart et trois quarts du chevauchement de la deuxième zone par la première couche isolante.

Selon un mode de réalisation, la première couche isolante s'étend sur toute la périphérie de la première zone.

Selon un mode de réalisation, au moins une partie de la troisième zone s'étend sur une profondeur supérieure à la profondeur des première et deuxième zones.

Selon un mode de réalisation, les première, deuxième et troisième zones sont en contact avec la première couche isolante.

Selon un mode de réalisation, le procédé comprend la formation, dans un substrat semiconducteur, d'un anneau de garde dans la périphérie de l'emplacement de la diode, l'anneau ayant un niveau de dopage sensiblement égal à celui de la troisième zone.

Selon un mode de réalisation, le procédé comprend la formation d'une deuxième couche isolante comprenant une première ouverture découvrant le substrat à l'intérieur de l'anneau et une partie de l'anneau et comprenant le dopage, à travers la première ouverture, d'une partie du substrat avec le niveau de dopage de la deuxième zone.

Selon un mode de réalisation, le procédé comprend la formation d'une troisième couche isolante et le dopage, à travers la troisième couche isolante, d'une partie du substrat avec le niveau de dopage de la première zone.

Selon un mode de réalisation, le procédé comprend la formation d'une deuxième ouverture découvrant partiellement l'emplacement de la première zone.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif comprenant une diode ;
la figure 2A représente partiellement le résultat d'une étape de fabrication du mode de réalisation de la figure 1 ;
la figure 2B représente partiellement le résultat d'une autre étape de fabrication du mode de réalisation de la figure 1 ;
la figure 2C représente partiellement le résultat d'une autre étape de fabrication du mode de réalisation de la figure 1 ;
la figure 2D représente partiellement le résultat d'une autre étape de fabrication du mode de réalisation de la figure 1 ; et
la figure 2E représente partiellement le résultat d'une autre étape de fabrication du mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, l'utilisation du dispositif comprenant la diode ne sera pas décrit en détail.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

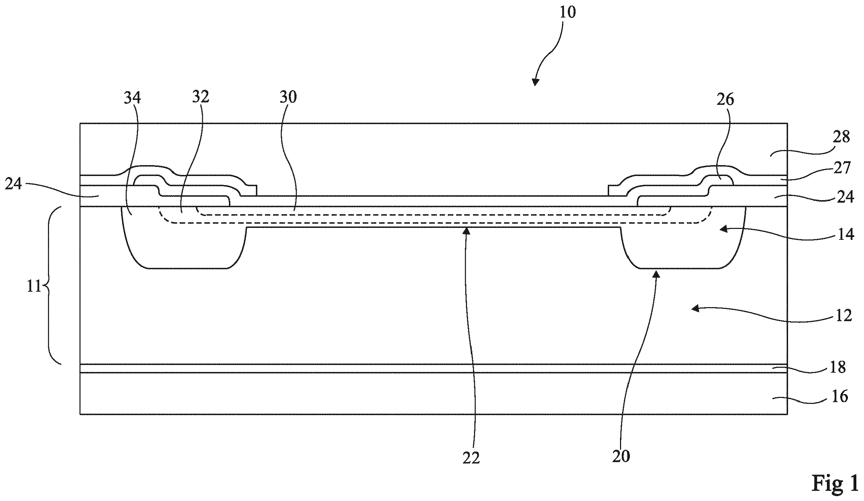

La figure 1 représente un mode de réalisation d'un dispositif comprenant une diode 10.

Le dispositif comprend un substrat 11. Le substrat 11 est en un matériau semiconducteur, par exemple en silicium. De préférence, la diode 10 est une diode fine. Autrement dit, l'épaisseur du substrat, correspondant par exemple à l'épaisseur de la diode, est de préférence inférieure à 150 µm, de préférence inférieure à 100 µm, par exemple sensiblement égale à 90 µm.

Le substrat 11 comprend une région 12. La région 12 est dans le même matériau semiconducteur que le substrat 11. La région 12 est dopée par un premier type de conductivité. De préférence, la région 12 est dopée de type N. La région 12 constitue alors la cathode de la diode 10.

Le dispositif comprend, en outre, une région 14 située sur, et de préférence en contact avec, la région 12. La région 14 est dans le même matériau semiconducteur que le substrat 11. La région 14 est dopée par un deuxième type de conductivité, différent du premier type de conductivité. De préférence, la région 14 est dopée de type P. La région 14 constitue alors l'anode de la diode 10. L'interface entre la région 12 et la région 14 constitue la jonction PN de la diode. La diode est ainsi une diode dite "verticale", c'est-à-dire que l'empilement de la région P et de la région N est vertical. Autrement dit, la jonction PN, c'est-à-dire le plan d'interface entre la région dopée P et la région dopée N est horizontal.

Le dispositif comprend, de plus, un support 16. Le support 16 est par exemple en un matériau conducteur, par exemple en cuivre.

Le substrat 11 est situé sur le support 16. De préférence, le substrat 11 est séparé du support 16 par une couche conductrice 18. La couche 18 est de préférence en un métal. La couche 18 est par exemple une couche de métal de soudure permettant de fixer le substrat 11 sur le support 16. La couche 18 constitue une électrode de la diode, connectée à la cathode.

Ainsi, le dispositif comprend un empilement comprenant, dans cet ordre, le support 16, la couche 18 et le substrat 11. De préférence, la région 12 constitue une partie inférieure du substrat 11 et la région 14 constitue une partie supérieure du substrat 11. L'empilement comprend donc de préférence, dans cet ordre, le support 16, la couche 18, la région 12 et la région 14.

Par exemple, la couche 18 recouvre entièrement le support 16 en regard de la diode 10. De même, le substrat 11 recouvre de préférence entièrement la couche 18 au niveau de la diode.

De préférence, la partie 12 s'étend donc à partir de la couche 18, c'est-à-dire à partir d'une face inférieure du substrat 11, jusqu'à l'interface avec la région 14. De préférence, la région 14 s'étend de l'interface avec la région 12 jusqu'à une face supérieure du substrat 11.

La région 14 comprend une partie 20, ou anneau de garde. La partie 20 est de préférence située à la périphérie de la diode 10. La partie 20 est ainsi à la périphérie de l'anode 14. Ainsi, la zone active de la diode 10 est, de préférence, située à l'intérieur de l'anneau 20 et/ou sous l'anneau 20.

La région 14 comprend, de plus, une partie 22, s'étendant à l'intérieur de l'anneau 20. La partie 20 entoure donc la partie 22. Plus précisément, la partie 22 s'étend sur toute la surface du substrat 11 à l'intérieur de l'anneau 20. La partie 20 est plus profonde que la partie 22, par exemple au moins deux fois plus profonde. La partie 22 a de préférence une profondeur sensiblement constante. Les parties 20 et 22 s'étendent toutes deux à partir de la face supérieure du substrat.

Le dispositif comprend, en outre une couche 24 en un matériau isolant. La couche 24 s'étend sur, de préférence en contact avec, la face supérieure du substrat 11. Plus précisément, la couche 24 s'étend de préférence sur au moins une partie de la partie 20 et sur la face supérieure du substrat 11 entourant la partie 20. La couche 24 ne s'étend de préférence pas sur la partie 22.

L'extrémité de la couche 24, c'est-à-dire la partie la plus proche de la partie 22 a par exemple une épaisseur inférieure au reste de la couche 24. La partie ayant une épaisseur inférieure est située sur la partie 20, de préférence uniquement sur la partie 20. La couche 24 a donc de préférence une première épaisseur, de préférence sensiblement constante, en regard du substrat hors de l'anneau 20 et, de préférence, sur une partie de l'anneau. La couche 24 a donc de préférence une deuxième épaisseur de préférence sensiblement inférieure à la première épaisseur, en regard d'une partie de la partie 20, au niveau de l'extrémité de la couche 24.

Le dispositif comprend en outre une couche 26 conductrice, par exemple en métal. La couche 26 est située sur, de préférence en contact avec, la partie 22. La couche 26 recouvre en outre au moins partiellement l'extrémité de la couche 24 ayant la deuxième épaisseur. De préférence, la couche 26 recouvre entièrement l'extrémité de la couche 24 ayant la deuxième épaisseur. La couche 26 recouvre de préférence partiellement la partie de la couche 24 ayant la première épaisseur. La couche 26 constitue une électrode de la diode, connectée à l'anode.

Le dispositif comprend une couche isolante 27. La couche 27 est une couche de passivation. La couche 27 recouvre la couche 24, de préférence entièrement, et recouvre partiellement la couche 26. Une partie, par exemple la partie centrale, de la couche 26 n'est pas couverte par la couche 27, permettant la formation de contacts électriques (non représentés) avec la couche 26. Le dispositif comprend, en outre, une couche 28 de protection. La couche 28 est de préférence en un matériau isolant. La couche 28 est par exemple en résine. La couche 28 recouvre la couche conductrice 26 et la couche 24.

La région 14 comprend trois niveaux de dopage. Le premier niveau de dopage est situé dans une zone 30 entourée par des traits pointillés. La zone 30 permet une connexion plus efficace entre la cathode et l'électrode 26. Le premier niveau de dopage correspond par exemple à un dopage compris entre 1e17 atomes/cm3 et 1e20 atomes/cm3. Un deuxième niveau de dopage est situé dans une zone 32 entourée par des traits pointillés. Le deuxième niveau de dopage correspond par exemple à un dopage compris entre 1e15 atomes/cm3 et 1e17 atomes/cm3. De préférence, le premier niveau de dopage est supérieur à au moins dix fois, de préférence au moins cent fois, la valeur du deuxième dopage. Les zones de la région 22 n'étant ni dans la zone 30 ni dans la zone 32 constituent une zone 34. La zone 34 est ainsi située dans la périphérie de la diode, autrement dit sur l'extérieur de la diode. La zone 34 a le troisième niveau de dopage. Le troisième niveau de dopage correspond par exemple à un dopage compris entre 1e14 atomes/cm3 et 1e17 atomes/cm3. De préférence, le deuxième niveau de dopage est supérieur à au moins dix fois, la valeur du troisième dopage.

La zone 30 est de préférence située au niveau de la face supérieure du substrat dans toute la partie 22. La zone 30 est ainsi en contact avec la couche 26. De plus, la zone 30 s'étend sous, et est en contact avec, la couche 24, en particulier sous l'extrémité de la couche 24 ayant la deuxième épaisseur. La couche 24 chevauche donc une partie de la zone 30.

La zone 32 entoure la zone 30. Ainsi, la zone 32 s'étend sous, et en contact avec, la zone 30. Autrement dit, la zone 32 s'étend en regard de la zone 30. De plus, la zone 32 s'étend le long des parois latérales de la zones 30, de manière à atteindre la couche 24. La zone 32 s'étend en regard de toute la partie 22. De plus, la zone 32 s'étend partiellement en regard de la couche 24. En particulier, la zone 32 s'étend en regard de l'extrémité de la couche 24 ayant la deuxième épaisseur. De préférence, la zone 32 s'étend jusqu'à la limite de la partie de la couche 24 ayant une épaisseur sensiblement constante et sensiblement égale à la première épaisseur. Autrement dit, la zone 32 s'étend jusqu'à la séparation entre la partie ayant une épaisseur sensiblement constante et sensiblement égale à la première épaisseur et la partie ayant une épaisseur inférieure à la première épaisseur. La zone 32 est ainsi en contact avec la couche 24.

En pratique, les zones 30 et 32 forment l'anode de la diode.

La zone 34 entoure de préférence la zone 32. Ainsi, la zone 34 s'étend de préférence sous, et en contact avec, la zone 32. De préférence, la zone 34 n'est pas en contact avec la zone 30. Autrement dit, la zone 34 s'étend en regard de la zone 30 et de la zone 32. La zone 34 s'étend de préférence en regard de toute la partie 22. De plus, la zone 34 s'étend de préférence, autour des zones 30 et 32, de manière à atteindre la couche 24. La zone 34 s'étend le long des parois latérales de la zone 32. Ainsi, la zone 34 est de préférence en contact avec la couche 24, de préférence avec la partie ayant la première épaisseur. De préférence, la zone 34 n'est pas en contact avec l'extrémité de la couche 24, c'est-à-dire avec la partie de la couche 24 ayant une épaisseur inférieure à la première épaisseur. La zone 34 est ainsi en contact avec la couche 24.

Ainsi, une partie de la couche 24, plus précisément une partie de l'extrémité, est en regard des zones 30, 32 et 34. Une autre partie de la couche 24, plus précisément une autre partie de l'extrémité, est en regard des zones 32 et 34, mais n'est pas en regard de la zone 30. Une partie de la couche 24, plus précisément une partie ayant une épaisseur sensiblement égale à la première épaisseur, est en regard de la zone 34 mais pas en regard des zones 30 et 32.

Dans un mode de réalisation préférentiel, la région 22 comprend uniquement des zones 30 et 32. Ainsi, la région 22 comprend une partie inférieure correspondant à la zone 32 et une partie supérieure correspondant à la zone 30. La zone 34 est ainsi uniquement présente dans la région 20. La zone 34 entoure donc, dans ce mode de réalisation, la zone active de la diode. La zone 34 se situe donc dans la périphérie de la diode.

Le chevauchement, ou recouvrement, de la zone 30 par la couche 24 s'étend de préférence sur une portion comprise entre un quart et trois quarts du chevauchement de la zone 32 par la couche 24. Autrement dit, le chevauchement de la zone 30 par la couche 24 s'étend de préférence sur une longueur comprise entre un quart et trois quarts de la longueur du chevauchement de la zone 32 par la couche 24. Par longueur, on entend la dimension la plus longue dans le plan de coupe de la figure 1, autrement dit, la dimension dans la direction entre l'extrémité de la couche 34 et la partie de la couche 24 ayant la première épaisseur.

Autrement dit, la surface du chevauchement de la zone 30 par la couche 24 correspond à une portion comprise entre un quart et trois quarts de la surface du chevauchement de la zone 32 par la couche 24.

Par exemple, le chevauchement de la zone 30 par la couche 24 s'étend de préférence sur une portion d'au moins 5 µm, de préférence d'au moins 10 µm, par exemple comprise entre 5 µm et 20 µm, par exemple sensiblement égale à 10 µm.

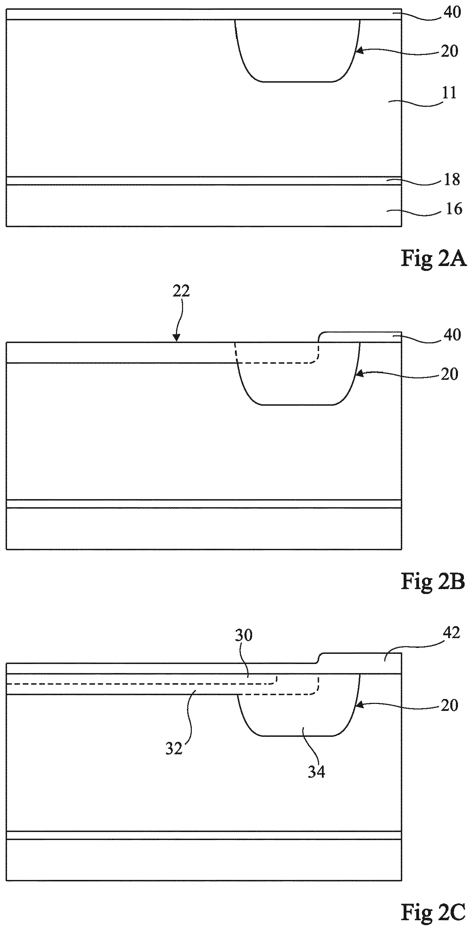

Les figures 2A à 2E illustrent des étapes, de préférence successives, de formation de la structure de la figure 1. Les figures 2A à 2E représentent uniquement une partie de la structure de la figure 1, les étapes du procédé étant effectuées de manière similaire dans la partie non représentée.

La figure 2A représente partiellement le résultat d'une étape de fabrication du mode de réalisation de la figure 1.

Au cours de cette étape, la couche 18 conductrice est formée sur le support 16. De préférence, la couche 18 recouvre entièrement le support 16 à l'emplacement de la diode 10.

Le support 16 est par exemple en un matériau isolant, par exemple en oxyde de silicium ou en nitrure de silicium, ou en un matériau semiconducteur, par exemple en silicium. La couche conductrice 18 est par exemple en un métal.

Le substrat semiconducteur 11, de préférence en silicium, est formé sur la couche 18, par exemple fixé sur le support par la couche 18. Le substrat 11 est ainsi au moins partiellement séparé du support par la couche conductrice 18.

De préférence, le substrat 11 est un substrat fin. Autrement dit, le substrat 11 a de préférence une hauteur inférieure à 150 µm, de préférence inférieure à 100 µm, par exemple sensiblement égale à 90 µm.

Une couche 40 est formée sur la surface du substrat 11. La couche 40 est un matériau isolant, par exemple de l'oxyde de silicium. De préférence, la couche 40 recouvre entièrement la face supérieure, c'est-à-dire la face la plus éloignée du support 16, du substrat 11.

L'étape de la figure 2A comprend, de plus, la formation de la région 20, c'est-à-dire de l'anneau de garde. La région 20 est formée en dopant, de préférence avec un dopant de type P, un anneau entourant l'emplacement de la zone active de la diode. De préférence, le dopage de la région 20 est compris entre 1e14 atomes/cm3 et 1e17 atomes/cm3.

La formation de la région 20 comprend par exemple la formation préliminaire d'un masque de gravure non représenté, par exemple en résine, recouvrant le substrat 11 à l'exception de l'emplacement de la région 20 situé en regard d'une ouverture. Le dopage du substrat 11 de manière à former la région 20 est effectué par l'intermédiaire de l'ouverture dans le masque. Le masque de gravure est retiré après la formation de la région 20.

L'anneau de garde s'étend de préférence sur moins de la moitié de la hauteur du substrat. L'anneau ne s'étend donc pas, de préférence, jusqu'à la couche 18 et le support 16. La région 20 est ainsi séparée du support 16 et de la couche 18 par une portion du substrat 11 n'ayant pas été dopée lors de la formation de la région 20.

La formation de l'anneau de garde comprend de préférence une étape de recuit.

La figure 2B représente partiellement le résultat d'une autre étape de fabrication du mode de réalisation de la figure 1.

Au cours de cette étape, la couche 40 est gravée de manière à former une ouverture découvrant l'emplacement de la zone 32, c'est-à-dire l'intérieur de l'anneau 20 et une partie de l'anneau, autrement dit, la région entourée par l'anneau et une partie de l'anneau. Ainsi, la couche 40 recouvre partiellement l'anneau 20 et recouvre le substrat 11 à l'extérieur de l'anneau 20. De préférence, la couche 40 est située aux emplacements de la partie de la couche 24 ayant la première épaisseur.

Cette étape comprend en outre la formation de la région 22. Plus précisément, cette étape comprend le dopage du substrat 11 par l'intermédiaire de l'ouverture formée dans la couche 40. La couche 40 sert ainsi de masque de gravure. L'emplacement de la zone 32 et, de préférence, l'emplacement de la zone 30, sont ainsi dopée avec un niveau de dopage correspondant au dopage de la zone 32. Ainsi, la région 22 et une partie de la région 20 sont dopées avec le niveau de dopage de la zone 32. Le niveau de dopage de la zone 32 s'arrête donc au niveau de l'extrémité de la couche 40.

La région dopée lors de cette étape a sensiblement la profondeur de la région 22 et est donc moins profonde que la région 20.

La figure 2C représente partiellement le résultat d'une autre étape de fabrication du mode de réalisation de la figure 1.

Cette étape comprend la croissance du matériau de la couche 40, de préférence de l'oxyde de silicium, sur la structure de la figure 2B. La couche 40 est ainsi remplacée par la couche 42. La couche 42 comprend une première partie, à l'emplacement de la couche 40 de la figure 2B, et une deuxième partie à l'emplacement de l'ouverture dans la couche 40. Les première et deuxième partie ont chacune une épaisseur sensiblement constante. L'épaisseur de la première partie est supérieure à l'épaisseur de la deuxième partie, par exemple au moins deux fois supérieure.

Cette étape comprend ensuite la formation de la zone 30. Plus précisément, cette étape comprend le dopage, ou surdopage, d'une partie de la zone dopée lors de l'étape de la figure 2B. Ainsi, la zone 30, plus fortement dopée que la zone 32, est formée. Cette étape de dopage est effectuée par l'intermédiaire d'une ouverture dans un masque de gravure non représenté.

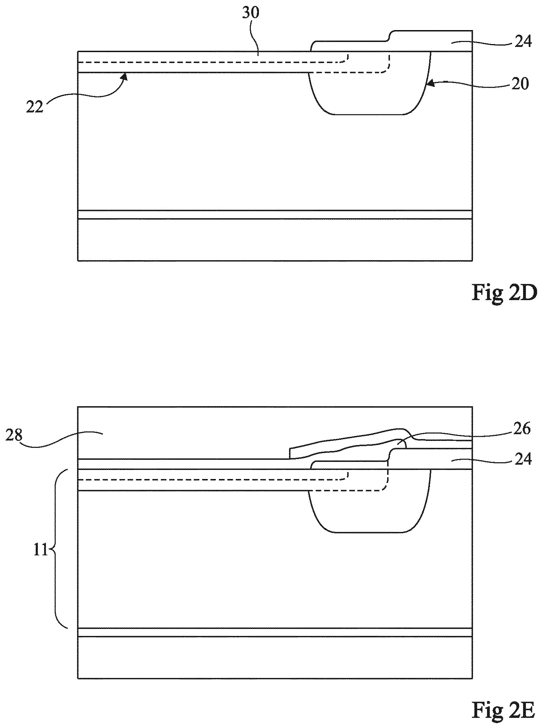

La figure 2D représente partiellement le résultat d'une autre étape de fabrication du mode de réalisation de la figure 1.

Au cours de cette étape, une ouverture est formée dans la couche 42, de manière à former la couche 24. L'ouverture dans la couche 42 découvre partiellement la zone 30. L'ouverture ne découvre pas entièrement la zone 30. Une partie périphérique de la zone 30 est couverte par la couche 24.

La figure 2E représente partiellement le résultat d'une autre étape de fabrication du mode de réalisation de la figure 1.

Au cours de cette étape, une couche conductrice est formée sur la structure de la figure 2D. Cette couche conductrice est ensuite gravée de manière à former la couche 26. La couche 26 est ainsi en contact avec le substrat 11 par l'ouverture dans la couche 24. La couche 26 forme ainsi une électrode de la diode.

La couche isolante 28 est ensuite formée sur la structure, recouvrant en particulier la couche 26.

La formation du dispositif peut aussi comprendre des étapes non représentées, par exemple la formation de vias conducteurs, traversant par exemple la couche 28 de manière à relier la couche 26 à d'autres composants électroniques.

On aurait pu choisir de ne pas effectuer l'étape correspondant à la figure 2C. Le dopage de la zone 30 serait alors effectué à travers l'ouverture de la couche isolante déposée dans l'étape de la figure 2D. La zone 30 ne s'étendrait donc pas sous la couche 24. Cependant, en fonctionnement, un réservoir de charges se formerait alors dans l'extrémité de la zone 30, c'est-à-dire la portion la plus proche de la couche 24. Cela entrainerait lors du fonctionnement, en particulier dans des diodes fines, la formation d'un filament de courant s'étendant de cette portion à la couche 18. Le long de ce filament, en particulier au niveau de la couche 18, la température augmenterait, par exemple jusqu'à des températures pouvant atteindre plus de 300 °C. Cela pourrait entrainer la dégradation de la diode et de la couche 18, par exemple en séparant la couche 18 du substrat.

Un avantage des modes de réalisation décrits est que le chevauchement de la zone 30 avec l'oxyde permet d'éviter la formation d'un réservoir de charges trop important dans un volume relativement faible. Cela diminue donc le risque de dégradation de la diode.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif comprenant une diode (10) dans laquelle l'anode de la diode comprend des première (30), deuxième (32) et troisième (34) zones, la première zone (30) recouvrant partiellement la deuxième zone (32) et ayant un niveau de dopage supérieur au niveau de dopage de la deuxième zone (32), la deuxième zone (32) recouvrant partiellement la troisième zone (34) et ayant un niveau de dopage supérieur au niveau de dopage de la troisième zone (34), une première couche isolante (24) chevauchant partiellement les première et deuxième zones.

2. Procédé de fabrication d'une diode (10) comprenant la formation de première (30), deuxième (32) et troisième (34) zones de l'anode de la diode, la première zone (30) recouvrant partiellement la deuxième zone (32) et ayant un niveau de dopage supérieur au niveau de dopage de la deuxième zone (32), la deuxième zone (32) recouvrant partiellement la troisième zone (34) et ayant un niveau de dopage supérieur au niveau de dopage de la troisième zone (34), une première couche isolante (24) chevauchant partiellement les première et deuxième zones.

3. Dispositif selon la revendication 1 ou procédé selon la revendication 2, dans lequel la première zone (30) est recouverte par la première couche isolante (24) et une couche conductrice (26).

4. Dispositif selon la revendication 1 ou 3 ou procédé selon la revendication 2 ou 3, dans lequel le niveau de dopage de la première zone (30) est au moins 10 fois supérieur au niveau de dopage de la deuxième zone (32) et le niveau de dopage de la deuxième zone (32) est au moins 10 fois supérieur au niveau de dopage de la troisième zone (34).

5. Dispositif selon l'une quelconque des revendications 1, 3 ou 4 ou procédé selon l'une quelconque des revendications 2 à 4, dans lequel le niveau de dopage de la première zone (30) est compris entre 1e17 atomes/cm3 et 1e20 atomes/cm3, le niveau de dopage de la deuxième zone (32) est compris entre 1e15 atomes/cm3 et 1e17 atomes/cm3, et le niveau de dopage de la troisième zone (34) est compris entre 1e14 atomes/cm3 et 1e17 atomes/cm3.

6. Dispositif selon l'une quelconque des revendications 1, 3 à 5 ou procédé selon l'une quelconque des revendications 2 à 5, dans lequel le chevauchement de la première zone (30) par la première couche isolante (24) s'étend sur une longueur au moins égale à 5 µm, de préférence au moins égale à 10 µm.

7. Dispositif selon l'une quelconque des revendications 1, 3 à 6 ou procédé selon l'une quelconque des revendications 2 à 6, dans lequel le chevauchement de la première zone (30) par la première couche isolante (24) s'étend sur une portion comprise entre un quart et trois quarts du chevauchement de la deuxième zone (32) par la première couche isolante (24).

8. Dispositif selon l'une quelconque des revendications 1, 3 à 7 ou procédé selon l'une quelconque des revendications 2 à 7, dans lequel la première couche isolante (24) s'étend sur toute la périphérie de la première zone (30).

9. Dispositif selon l'une quelconque des revendications 1, 3 à 8 ou procédé selon l'une quelconque des revendications 2 à 8, dans lequel au moins une partie de la troisième zone (34) s'étend sur une profondeur supérieure à la profondeur des première (30) et deuxième (32) zones.

10. Dispositif selon l'une quelconque des revendications 1, 3 à 9 ou procédé selon l'une quelconque des revendications 2 à 9, dans lequel les première (30), deuxième (32) et troisième (34) zones sont en contact avec la première couche isolante (24).

11. Procédé selon l'une quelconque des revendications 2 à 10, comprenant la formation, dans un substrat semiconducteur (11), d'un anneau (20) de garde dans la périphérie de l'emplacement de la diode (10), l'anneau ayant un niveau de dopage sensiblement égal à celui de la troisième zone (34).

12. Procédé selon l'une quelconque des revendications 2 à 11, comprenant la formation d'une deuxième couche isolante (40) comprenant une première ouverture découvrant le substrat (11) à l'intérieur de l'anneau et une partie de l'anneau et comprenant le dopage, à travers la première ouverture, d'une partie du substrat avec le niveau de dopage de la deuxième zone (32).

13. Procédé selon l'une quelconque des revendications 2 à 12, comprenant la formation d'une troisième couche isolante (24) et le dopage, à travers la troisième couche isolante, d'une partie du substrat (11) avec le niveau de dopage de la première zone (30).

14. Procédé selon la revendication 13, comprenant la formation d'une deuxième ouverture découvrant partiellement l'emplacement de la première zone (30).
